# EUROPEAN PATENT APPLICATION

(11) **EP 1 906 265 A1**
(43) Date of publication of application: **02.04.2008**
(21) Application number: 06712679.7
(22) Date of filing: 31.01.2006
(51) Int. Cl.: G03H 1/02

(54) **VOLUME PHASE HOLOGRAM RECORDING MATERIAL, PROCESS FOR PRODUCING THE SAME, AND RECORDED MATERIAL**

(30) Priority: 11.07.2005 JP 2005201983
(71) Applicant: TOAGOSEI CO., LTD., Tokyo 105-8419 (JP)
(72) Inventor: SATOU, Shin, Nagoya-shi, Aichi 4550027 (JP); SASAKI, Hiroshi, Nagoya-shi, Aichi 4550027 (JP)
(74) Representative: Wilhelms . Kilian & Partner Patentanwälte
(86) International application number: PCT/JP2006/301536
(87) International publication number: WO 2007/007436

(57) **Abstract**

It is an object of the present invention to provide a photopolymer-based volume phase hologram recording material that can record/reproduce image information with excellent properties in terms of bit error rate (BER) or signal to noise ratio (SNR), which expresses the ratio of digital signal to noise, and that is suitable for application to holographic information recording, etc., and to provide a volume phase hologram recorded material employing the material. In accordance with the present invention, it is possible to record/reproduce a volume phase hologram with reduced noise, etc. in data hologram recording by a produced polymer that has been polymerized by means of interference fringes generated by interference between information light and reference light, the produced polymer having a weight-average molecular weight of 1,000 to 3,000,000. Furthermore, when a hologram is recorded using information light and reference light, the present invention provides a volume phase hologram recording material that comprises a chain transfer agent.

## Description

The present invention relates to a recording material suitable for recording a volume phase hologram, etc., a production process therefor, and a recorded material for a recording/reproduction system therefor.

In a hologram, interference fringes formed by interference between two kinds of coherent light, called information light and reference light, are recorded on a photosensitive material, and by irradiating the photosensitive material with light having the same wavelength as that of the reference light from the same direction as the reference light, a beam having the same information as the information light is generated from the recorded photosensitive material, that is, reproduced.

As an example of application of this holographic technique, the following example is well known. That is, a 3D subject is irradiated with coherent light, and interference fringes formed by interference between coherent light reflected from the subject and a reference light are recorded on a photosensitive material. By irradiating the recorded photosensitive material with the same reference light as that used for recording, a replica 3D image of the subject is reproduced and can be viewed at the position where the subject was originally present; this is called a 3D hologram, and is widely known.

This holographic technique is also applied, in addition to the 3D hologram, to a three-dimensional image display element, an optical element, etc., and these are called holographic optical elements (HOE). Furthermore, it is expected that there will be applications in the field of high capacity memory for recording/reproducing digital information, that is, the field of holographic information recording.

Holograms are classified into amplitude holograms and phase holograms according to the recording configuration for the interference fringes. Furthermore, they are classified into thin holograms and thick holograms (volume holograms) according to the thickness of a recording layer (ref. e.g. Nonpatent Publication 1). Among them, the so-called volume phase hologram, in which interference fringes are recorded in a configuration in which there is a refractive index distribution or refractive index modulation inside a relatively thick recording layer, has been put into practical use in three-dimensional displays and HOEs because of high diffraction efficiency and excellent wavelength selectivity. As a photosensitive material for recording such a volume phase hologram, silver halide, dichromated gelatin (DCG), etc. have been conventionally used (ref. e.g. Nonpatent Publication 1). However, since they require wet development or a complicated developing and fixing treatment, they are not suitable for the industrial production of holograms, and there is also the problem that images might disappear after being recorded due to moisture absorption.

In recent years various kinds of photopolymer materials have been proposed as photosensitive materials for volume phase holograms. Since they do not require a complicated development treatment, which is needed when using conventional silver halide type or DCG type photosensitive materials, and a volume phase hologram can be recorded using only a dry process, they can be said to be useful for the industrial production of holograms.

With regard to a photopolymer-based photosensitive composition used for producing a volume phase hologram, there is a photosensitive composition that has as main components a radically polymerizable monomer, a binder polymer, a radical photopolymerization initiator, and a sensitizing dye, and utilizes a difference in refractive index between a polymer from the radically polymerizable monomer and the binder polymer (ref. e.g. Patent Publication 1). That is, when a film formed from this photosensitive composition is exposed to coherent light, radical polymerization is initiated in an area of the interference fringes in which the light is strong; this results in concentration gradients of the radically polymerizable monomer and the polymer therefrom and, moreover, the radically polymerizable monomer diffuses from an area where light is weak to an area where light is strong. As a result, the concentration distributions of the radically polymerizable monomer and the polymer therefrom vary according to the intensity within the interference fringes, and this is recorded as a difference in refractive index.

Furthermore, a material system employing a combination of radical polymerization and cationic polymerization has been reported as a hologram recorded material (ref. e.g. Patent Publication 2). In this publication, a system employing a monomer having a diarylfluorene framework as a high refractive index radically polymerizable monomer and a cationically polymerizable monomer having a refractive index that is smaller than that of the radically polymerizable monomer is disclosed. In this system, the high refractive index component undergoes radical polymerization during hologram exposure, and an image is subsequently fixed by cationic polymerization during exposure for fixation. Other than the above, a material system employing cationic polymerization has also been disclosed (ref. e.g. Patent Publication 3).

In a case in which the above-mentioned photopolymerization technique is applied to a hologram, a spatial distribution is made to occur in the concentration of monomer and polymer so as to correspond to bright areas and dark areas of the interference fringes, that is, the spatial distribution of light intensity of the interference fringes (this causes a difference between the average refractive index of places where the monomer has polymerized and the refractive index of other places). A photopolymer-based volume phase hologram recording material for recording these interference fringes as a refractive index distribution or refractive index modulation does not require a complicated development treatment, which is needed when using a conventional silver halilde photosensitive material or dichromated gelatin, and a volume phase hologram can be recorded using only a hologram exposure process. Because of this, the photopolymer-based volume phase hologram recording material is sufficiently usable as a recording material for a 3D image display such as a three-dimensional display.

However, in the photopolymer-based volume phase hologram recording material, in which a polymerizable monomer is dispersed in a matrix serving as a reaction site and a retaining body for the hologram exposure process, it is difficult to adjust compatibility between the monomer and the matrix or between the matrix and a polymer produced by the hologram exposure, and there is the problem that light scattering by the recording material itself is larger than a case with a conventionally used DCG, etc. Because of this, a recording material that causes little light scattering such as DCG is used as a master hologram for mass-producing a 3D image display element.

On the other hand, in recent years application of the holographic technique to the field of high capacity memory for recording/reproducing digital information, that is, the so-called holographic information storage (HIS) technique, has been investigated (ref. e.g. Nonpatent Publication 2). HIS is a recording/reproduction method to which the principle of hologram recording is applied and in which interference fringes formed by interference between reference light and information light that has digital information superimposed thereon are recorded on a photosensitive material, and the original digital information is read out by demodulating the information light reproduced from the interference fringes by reproduction light.

Digital information represented as a two-dimensional dot form or a lattice form is superimposed on coherent information light by means of a spatial light modulator (SLM) such as a digital micromirror (DMM), and a photosensitive material is then irradiated with the coherent information light together with coherent reference light, thus carrying out hologram recording. Reproduction thereof is carried out by irradiating the recorded material with the reference light. That is, the digital information in the two-dimensional dot form or the lattice form is read out by the reference light and demodulated as digital information by receiving the light by means of a charge-coupled device (CCD), a CMOS image pickup device, etc. Although it is different from a recording/reproduction method for a 3D image for a three-dimensional display in terms of the SLM or the CMOS image pickup device being used, the two methods are fundamentally the same in terms of recording/reproducing a specific optical image. However, since a large amount of digital data are recorded in HIS, holograms are generally superimposed; this is called multiplex recording. That is, unlike the recording of a 3D image for a three-dimensional display, HIS multiplex-records a few tens to a few hundreds of holograms per recording site or per recording volume. Furthermore, since the purpose of HIS is to record and store a large amount of information, the accuracy with which the recorded digital information is stored is important. The accuracy of recording/reproducing digital information is evaluated using bit error rate (BER), which is an indicator showing the number of errors contained in reproduced digital information, signal to noise ratio (SNR), which is expresses the ratio of digital signal to noise, etc. (ref. e.g. Nonpatent Publication 3, Nonpatent Publication 4).

As described above, HIS and the recording of a 3D image for a three-dimensional display are the same in terms of an optical image being recorded/reproduced, but since the former employs the technique called multiplex recording, it is important to maintain the quality of the recorded image, that is, how high quality the BER or the SNR is.

Unlike DCG, the photopolymer-based volume phase hologram recording material is a recording material suitable for HIS from the viewpoint of a complicated post-treatment being unnecessary, but there is much light scattering due to the recording material itself (ref. e.g. Nonpatent Publication 5). Because of this, the photopolymer-based volume phase hologram recording material simultaneously records noise due to the light scattering during recording, thus degrading the BER or the SNR and, moreover, during multiplex recording the noise is also superimposed, which imposes a limit on the multiplex recording performance.

Because of this, a method in which light scattering noise is reduced by improving the compatibility of the polymerizable monomer and the produced polymer with the matrix has been proposed (ref. e.g. Patent Publication 4). Although this method, which reduces the light scattering by adjusting the compatibility, is excellent, no combination of materials has been found that can maintain the compatibility of the polymerizable monomer and the produced polymer with the matrix in a desirable state while maintaining at a certain level properties such as diffraction efficiency that are required for a high performance hologram recording material. Moreover, in accordance with the disclosed technique, image information quality when carrying out multiplex recording, that is, the BER or the SNR, cannot be maintained at a high level.

Compared with the conventional DCG or silver halide-based hologram recording material, the above photopolymer-based volume phase hologram recording material is excellent as a recording material for industrial production from the viewpoint of there being no complicated post-treatment after recording, etc. However, the quality of a recorded image is poor compared with that obtained by the conventional DCG, etc.

The photopolymer-based volume phase hologram recording material utilizes the difference in refractive index between a matrix and a polymer produced from a polymerizable monomer after hologram recording. In order to obtain a clear holographic image, a combination of materials that gives a larger difference in refractive index is employed. However, with regard to materials that give a large difference in refractive index between the polymer and the polymer matrix, it is generally difficult to improve the compatibility therebetween. When the compatibility is insufficient, the polymer undergoes phase separation within the matrix, and cloudiness can be observed even by eye. Such cloudiness is evidence of the occurrence of light scattering, and the quality of the recorded image is degraded.

Therefore, the materials mixed and the composition are carefully selected so that phase separation does not occur within the recording material. However, there is a limit to such adjustment of compatibility, and the reduction in noise level is limited.

It is difficult for a conventional photopolymer-based volume phase hologram recording material to achieve a high definition hologram recording that would be comparable to DCG.
(Patent Publication 1) JP-A-02-3081 (JP-A denotes a Japanese unexamined patent application publication.)
(Patent Publication 2) JP-A-05-107999
(Patent Publication 3) JP-PCT-2001-523842 (JP-PCT denotes a published Japanese translation of a PCT application.)
(Patent Publication 4) JP-A-11-352303
(Nonpatent Publication 1) Toshihiro Kubota, 'Horografii Nyumon -Genri to Jissai-(Introduction to Holography -Principles and Practice-), Chapter 2 Types of Hologram and Image Reproduction (p 21-43), Chapter 6 Recording Materials and Evaluation of their Properties (p 96-107)', Asakura Shoten,1995
(Nonpatent Publication 2) H. K. Coufal et al., 'Holographic Data Storage', Springer series in optical science, 2000,
(Nonpatent Publication 3) G. T. Sincerbox, 'Holographic Data Storage: History and Physical Principles', Springer series in optical science, 2000, p3-20.
(Nonpatent Publication 4) G. Barbastathis and one other, 'Holographic Data Storage: Volume Holographic Multiplexing Methods', Springer series in optical science, 2000, p21-62.
(Nonpatent Publication 5) R. M. Shelby, 'Holographic Data Storage: Media Requirements for Digital Holographic Data Storage', Springer series in optical science, 2000, p101-111.

It is an object of the present invention to provide a photopolymer-based volume phase hologram recording material that can record/reproduce image information having excellent properties in terms of the bit error rate (BER) or the signal to noise ratio (SNR), which shows the ratio of digital signal to noise, and that is suitable for application in holographic information recording, etc., to provide a production process therefor, and to provide a volume phase hologram recorded material employing the material.

As a result of various investigations by the present inventors in order to solve the above-mentioned problems, it has been found that, in hologram recording of data, when the weight-average molecular weight of a produced polymer that has been polymerized by interference fringes generated due to interference between information light and reference light is 1,000 to 3,000,000, it is possible to record and reproduce a volume phase hologram with reduced noise, etc., and the present invention has thus been accomplished.

That is, it is a volume phase hologram recording material for recording a hologram using information light and reference light, a produced polymer that has been polymerized by interference fringes generated from the information light and the reference light having a weight-average molecular weight of 1,000 to 3,000,000.

Furthermore, the present invention is the volume phase hologram recording material wherein it comprises a chain transfer agent.

Moreover, the present invention is a volume phase hologram recording material wherein it comprises a polymer matrix, a polymerizable monomer, a photopolymerization initiator, and a chain transfer agent.

It is the volume phase hologram recording material wherein this chain transfer agent is a chain transfer agent for radical polymerization.

Furthermore, the present invention is a volume phase hologram recorded material comprising a produced polymer that has been polymerized from a polymerizable monomer by interference fringes generated from information light and reference light, the produced polymer having a weight-average molecular weight of 1,000 to 3,000,000.

In accordance with use of the volume phase hologram recording material of the present invention, it is possible to carry out recording and reproduction of a hologram with low noise. Furthermore, in accordance with use of the volume phase hologram recording material of the present invention, it is possible to easily produce a recorded material for which higher quality recording properties than for a normal hologram are required, such as in holographic digital data recording.

In accordance with use of the volume phase hologram recording material of the present invention, a hologram can be recorded and reproduced with low noise. Furthermore, in accordance with use of the volume phase hologram recording material of the present invention, it is possible to easily produce a recording medium for which higher quality recording properties than those for a normal hologram are required, such as in holographic digital data recording.

### Brief Description of Drawings

FIG. 1 is a schematic diagram of a hologram recording cell within which a volume phase hologram recording material has been enclosed.
FIG. 2 is a reproduced image of recording medium A
FIG. 3 is a reproduced image of comparative recording medium A

### Explanation of Reference Symbols

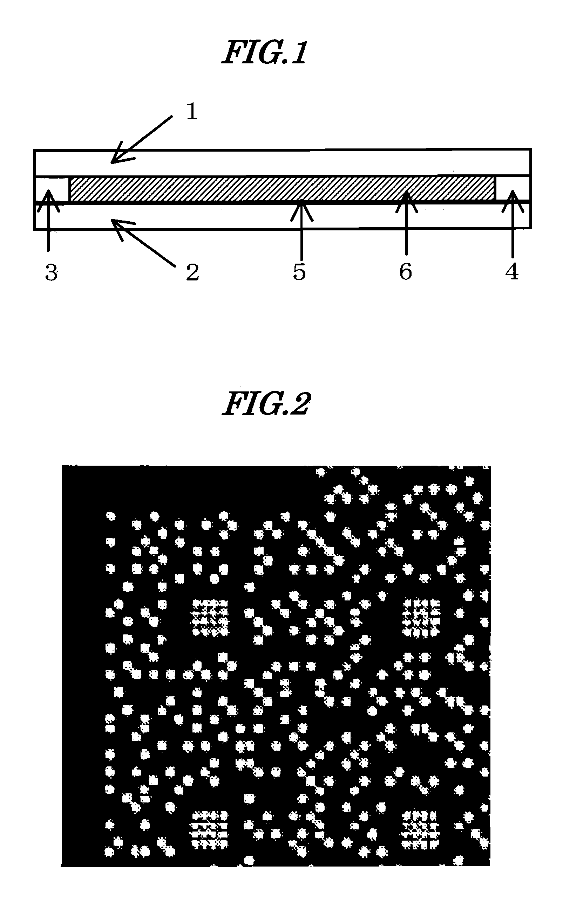

1 in FIG. 1: substrate 1 (e.g. glass)
2 in FIG. 1: substrate 2 (e.g. glass)
3 in FIG. 1: spacer 1
4 in FIG. 1: spacer 2
5 in FIG. 1: vapor-deposited aluminum layer
6 in FIG. 1: volume phase hologram recording material

The present invention provides a volume phase hologram recording material comprising a polymerizable monomer that can be photopolymerized by interference fringes generated from information light and reference light, wherein the recording material comprises a polymer matrix, a photopolymerization initiator, and a chain transfer agent, the chain transfer agent having a content that enables the weight-average molecular weight of a polymer produced by photopolymerization to be controlled so as to be in the range of 1,000 to 3,000,000.

The present invention also provides a volume phase hologram recorded material comprising a polymer that has been produced by polymerization of a polymerizable monomer by interference fringes generated from information light and reference light, the produced polymer having a weight-average molecular weight of 1,000 to 3,000,000.

Furthermore, the present invention provides a process for producing a volume phase hologram recording material, the process comprising a step of preparing a composition comprising a polymer matrix, a polymerizable monomer, a photopolymerization initiator, and a chain transfer agent, and a step of forming interference fringes generated from information light and reference light in the composition and producing a polymer from the polymerizable monomer in the presence of the chain transfer agent.

The volume phase hologram recording material comprising a chain transfer agent of the present invention can carry out high quality recording and reproduction of information with low noise.

The chain transfer agent referred to in the present invention is a chain transfer agent for radical polymerization or a chain transfer agent for cationic polymerization. This chain transfer agent abstracts a radial or a cation from the growing end of a polymerization reaction to thus stop the growth of the growing end. The radial or cation that has transferred to the chain transfer agent becomes a new polymerization reaction initiating species and is added to a polymerizable monomer, thus initiating growth of a new polymer. This process is called chain transfer of radical polymerization or cationic polymerization, and increasing the frequency of chain transfer enables the molecular weight of the polymer produced to be reduced.

As the chain transfer agent in the present invention, a degenerative chain transfer agent is preferable, and it is more preferable for it to be for radical polymerization.

Since the present invention enables the molecular weight of the polymer produced from the polymerizable monomer of the volume phase hologram recording material to be controlled, noise due to light scattering from the hologram recorded material of the present invention is reduced, and a hologram with a higher resolution can be recorded. Furthermore, with regard to the volume phase hologram recording material of the present invention, after a hologram is recorded, by irradiating the entire surface of the recording material with light, degradation of the recording can be suppressed compared with a case in which no chain transfer agent is contained. That is, by irradiating the entire surface of the volume phase hologram recording material after a hologram is recorded, it is possible to suppress further progress of polymerization. Because of this, the volume phase hologram recording material of the present invention improves the storage stability of media after a hologram is recorded.

### Volume phase hologram recording material

The volume phase hologram material of the present invention comprises as main components a photopolymerization initiator for generating a radical or a cation by irradiation with light, a radically polymerizable monomer or cationically polymerizable monomer (called a 'polymerizable monomer'), a polymer matrix serving as a polymerization site for the polymerizable monomer, and a chain transfer agent for controlling the molecular weight of a polymer produced by polymerization of the polymerizable monomer (called a produced polymer).

### Polymerizable monomer

As the polymerizable monomer in the present invention, an addition-polymerizable monomer is preferable; examples thereof include a radically polymerizable monomer and a cationically polymerizable monomer, and a radically polymerizable monomer is preferable. As the polymerizable monomer in the present invention, monofunctional and polyfunctional polymerizable monomers are preferable, and a monofunctional polymerizable monomer is more preferable.

When a monofunctional polymerizable monomer and a polyfunctional polymerizable monomer are contained as the polymerizable monomer in the present invention, if the total of the monofunctional polymerizable monomer and the polyfunctional polymerizable monomer is 100 parts, the content of the polyfunctional polymerizable monomer is preferably 20 parts or less, more preferably 10 parts or less, and yet more preferably 5 parts or less. When a polyfunctional polymerizable monomer is contained, it is contained at 0.1 parts or greater.

Preferred examples of the polymerizable monomer of the present invention include (meth)acrylates, (meth)acrylamides, styrenes, substituted styrenes, vinyl monomers, vinylnaphthalenes, and substituted vinylnaphthalenes, which have a radically polymerizable ethylenic double bond. Among them, (meth)acrylates are more preferable in the present invention since they give a high polymerization rate. The (meth)acrylate referred to here means an acrylic acid ester and/or a methacrylic acid ester, and (meth)acrylamide, etc. have the same meaning.

Specific examples of the polymerizable monomer in the present invention include a (meth)acrylate of a chain, branched, or cyclic alkyl alcohol such as methyl, ethyl, propyl, isopropyl, *n*-butyl, *sec*-butyl, t*ert*-butyl, pentyl, neopentyl, hexyl, heptyl, octyl, nonyl, dodecyl, 2-methylbutyl, 3-methylbutyl, 2-ethylbutyl, 1,3-dimethylbutyl, 2-ethylhexyl, 2-methylpentyl, cyclohexyl, adamantyl, isobornyl, dicyclopentanyl, or tetrahydrofurfuryl alcohol; a hydroxyalkyl (meth)acrylate such as 2-hydroxyethyl (meth)acrylate or 2-hydroxypropyl (meth)acrylate; a (meth)acrylate having an aromatic ring such as phenyl, 4-methoxycarbonylphenyl, 4-ethoxycarbonylphenyl, 4-butoxycarbonylphenyl, 4-*tert*-butylphenyl, benzyl, 4-phenylethyl, 4-phenoxydiethylene glycol, 4-phenoxytetraethylene glycol, 4-phenoxyhexaethylene glycol, or 4-biphenyl; a (meth)acrylate of an alkylene oxide adduct of a phenol, such as phenoxyethyl (meth)acrylate or a halogen-substituted derivative thereof (preferred examples of the halogen atom of the halogen-substituted derivative include fluorine, chlorine, and bromine); a (meth)acrylate containing an iron atom such as ferrocenylmethyl or ferrocenylethyl; a (meth)acrylate containing a halogen atom such as trifluoroethyl, tetrafluoropropyl, heptadecafluorodecyl, octafluoropentyl, or 2,3-dibromopropyl; a (meth)acrylate containing a silicon atom such as trimethoxysilylpropyl; an epoxy group-containing (meth)acrylate such as glycidyl acrylate or glycidyl methacrylate; a (meth)acrylate containing an amino group such as *N,N-*dimethylaminoethyl, *N,N*-diethylaminoethyl, or N-tert-butylaminoethyl; a mono(meth)acrylate of an aliphatic hydroxy compound such as ethylene glycol, methoxyethylene glycol, diethylene glycol, triethylene glycol, tetraethylene glycol, neopentyl glycol, 1,3-propanediol, 1,4-butanediol, 1,5-pentanediol, 1,6-hexanediol, 1,10-decanediol, tripropylene glycol, trimethylolpropane, pentaerythritol, dipentaerythritol, sorbitol, mannitol, or tricyclodecanedimethanol, or a (meth)acrylate of an alkylene oxide adduct thereof; a di(meth)acrylate of bisphenol A, isocyanuric acid, ethylene glycol, or propylene glycol, and a di(meth)acrylate of an alkylene oxide adduct of these alcohols; a tri(meth)acrylate of pentaerythritol, trimethylolpropane, or isocyanuric acid, and a tri(meth)acrylate of an alkylene oxide adduct of these alcohols; and a poly(meth)acrylate of pentaerythritol or dipentaerythritol.

Furthermore, specific examples of the polymerizable monomer in the present invention include a (meth)acrylamide such as acrylamide, N-butylacrylamide, or N,N-dimethylacrylamide; a styrene such as styrene, 4-bromostyrene, perfluorostyrene, α-methylstyrene, or vinyltoluene; and a vinyl monomer such as butadiene, isoprene, acrylonitrile, vinyl acetate, vinyl chloride, vinylidene chloride, N-vinylpyrrolidone, N-vinylcarbazole, vinylpyridine, vinylpyrrolidine, maleic anhydride, or diallyl phthalate.

In the present invention, the difference in refractive index between the polymer matrix and the polymerizable monomer is preferably at least 0.0001, more preferably at least 0.0003, and yet more preferably at least 0.0005. The difference is preferably at most 0.03, preferably at most 0.02, and yet more preferably at most 0.01. It is not desirable for the difference to exceed 0.03 since the balance between the polymer matrix and the polymerizable monomer in the recording material might break down. It is not desirable for the difference to be less than 0.0001 since modulation of the refractive index is poor and the BER might be high. The refractive index referred to here is a value measured at 25°C, and preferably a value measured at the same wavelength as that of the reference light.

Furthermore, when the molecular weight of the polymerizable monomer is high, diffusion in the polymer matrix is suppressed, and the reaction rate might be degraded. From this viewpoint, the molecular weight is preferably 1,000 or less, more preferably 800 or less, and yet more preferably 600 or less.

As the polymerizable monomer used in the present invention, phenyl (meth)acrylate, tribromophenyl (meth)acrylate, dibromophenyl (meth)acrylate, monobromophenyl (meth)acrylate, phenylphenyl (meth)acrylate, cumylphenyl (meth)acrylate, alkylene oxide-modified forms thereof, bromostyrene, dibromostyrene, tribromostyrene, etc. are more preferable, and phenyl (meth)acrylate, tribromophenyl (meth)acrylate, dibromophenyl (meth)acrylate, monobromophenyl (meth)acrylate, phenylphenyl (meth)acrylate, cumylphenyl (meth)acrylate, alkylene oxide-modified forms thereof, etc. may particularly preferably be used.

### Photopolymerization initiator

As a photopolymerization initiator used in the present invention, a photopolymerization initiator that generates a radical or a photopolymerization initiator that generates a cation when irradiated with light at 350 to 700 nm may be used, and a photopolymerization initiator that generates a radical is preferable.

The present invention may employ in combination a sensitizer in order to increase generation of the radical from the photopolymerization initiator by irradiation with light, and it is preferable to employ it in combination.

Specific examples of the photopolymerization initiator used in the present invention include benzoins such as benzoin, benzoin methyl ether, and benzoin propyl ether; acetophenones such as acetophenone, 2,2-dimethoxy-2-phenylacetophenone, 2,2-diethoxy-2-phenylacetophenone, 1,1-dichloroacetophenone, 1-hydroxycyclohexyl phenyl ketone, 2-methyl-1-[4-(methylthio)phenyl]-2-morpholinopropan-1-one, and N,N-dimethylaminoacetophenone; anthraquinones such as 2-methylanthraquinone, 1-chloroanthraquinone, and 2-amylanthraquinone; thioxanthones such as 2,4-dimethylthioxanthone, 2,4-diethylthioxanthone, 2-chlorothioxanthone, and 2,4-diisopropylthioxanthone; ketals such as acetophenone dimethyl ketal and benzil dimethyl ketal; benzophenones such as benzophenone, methylbenzophenone, 4,4'-dichlorobenzophenone, 4,4'-bisdiethylaminobenzophenone, 1,3-di(t-butyldioxycarbonyl)benzophenone, 3,3',4,4'-tetrakis(*t*-butyldioxycarbonyl)benzophenone, Michler's Ketone, and 4-benzoyl-4'-methyldiphenylsulfide; 2,4,6-trimethylbenzoyldiphenylphosphine oxide, *N*-phenylglycine, 2,4,6-tris(trichloromethyl)-s-triazine, 3-phenyl-5-isooxazolone, 2-mercaptobenzimidazole, imidazole dimers, bis(η-5-2,4-cyclopentadien-1-yl)bis[2,6-difluoro-3-(1H-pyrrol-1-yl)phenyl] titanium, which is commercially available as CGI-784 from Ciba, and 5,7-diiodo-3-butoxy-6-fluorone, which is commercially available as H-Nu470 from SpectraGroup Limited.

The photopolymerization initiator used in the present invention is used by appropriately selecting one that is sensitive to the wavelength of light used for recording a hologram. The photopolymerization initiator may be used singly or in a combination of two or more kinds.

Furthermore, when a compound that is not sensitive to the wavelength of the light used for recording a hologram is used as the photopolymerization initiator, it is possible to use in combination, as an initiation adjuvant, a dye that has absorption at the wavelength and that can make the photopolymerization initiator generate a radical by using it in combination with the photopolymerization initiator. Such a dye is widely known as a sensitizer or a sensitizing dye.

Examples of the sensitizing dye used in the present invention include xanthene, thioxanthene, cyanine, merocyanine, coumarin, ketocoumarin, eosin, erythrosine, titanocene, naphthacene, thiopyrylium, quinoline, styrylquinoline, oxonol, cyanine, rhodamine, and pyrylium-based compounds, 5,12-bis(phenylethynyl)naphthacene, and rubrene. When a sensitizing dye having absorption in the region of light used for reading out information from the volume phase hologram recorded material is used and high transparency is required, it is preferable to use one that becomes colorless after hologram recording is complete. This loss of color is preferably induced by heating or UV irradiation.

### Polymer matrix

The polymer matrix of the present invention is one that retains photopolymerization system components such as a photopolymerization initiator, a polymerizable monomer, and a chain transfer agent. The polymer matrix may comprise any component as long as it is in a range that does not interfere with the photopolymerization.

The polymer matrix of the present invention is preferably transparent in the wavelength region of light used for recording and reproducing a hologram. Furthermore, it has a level of shape stability such that the recorded hologram is not destroyed. The materials of the polymer matrix that can be used in the present invention are broadly divided into two classes in terms of polymer properties. One thereof is a non-crosslinked polymer matrix employing a straight chain, branched, comb-shaped, etc. non-crosslinked polymer as a material, and the other is a crosslinked polymer matrix employing a crosslinked polymer in which polymer chains are crosslinked together at a plurality of sites.

Examples of the material of the polymer matrix used in the present invention include solvent-soluble and thermoplastic polymers such as acrylates, alpha-alkyl acrylate esters, acidic polymers, and interpolymers, such as polymethyl methacrylate and polyethyl methacrylate; polyvinyl esters such as polyvinyl acetate, polyvinyl acetate/acrylate, polyvinyl acetate/methacrylate, and hydrolyzable polyvinyl acetates; ethylene/vinyl acetate copolymers; saturated and unsaturated polyurethanes (urethane-based polymers); butadiene and isoprene polymers and copolymers, high molecular weight polyethylene oxides of polyglycols having an average molecular weight of on the order of 4,000 to 1,000,000; epoxides such as epoxides having an acrylate or methacrylate group; polyamides such as N-methoxymethyl polyhexamethylene adipamide; cellulose esters such as cellulose acetate, cellulose acetate succinate, and cellulose acetate butyrate; cellulose ethers such as methyl cellulose and ethyl cellulose; polycarbonates; and polyvinylacetals such as polyvinylbutyral and polyvinylformal. They may be used singly or in a combination of a plurality of kinds.

Examples of the material of the polymer matrix used in the present invention include those formed by cationic epoxy polymerization, cationic vinyl ether polymerization, cationic alkenyl ether polymerization, cationic allene ether polymerization, cationic ketene acetal polymerization, epoxy-amine addition polymerization, epoxy-thiol addition polymerization, unsaturated ester-amine addition polymerization (involving Michael addition), unsaturated ester-thiol addition polymerization (involving Michael addition), vinyl-silicon hydride addition polymerization (hydrosilylation), isocyanate-hydroxyl addition polymerization (urethane formation), isocyanate-thiol addition polymerization, and isocyanate-amine addition polymerization (urea formation).

The above-mentioned reactions are made possible or promoted by an appropriate catalyst. For example, cationic epoxy polymerization proceeds rapidly by the use of a catalyst containing BF₃ as a main component, other cationic polymerizations proceed in the presence of protons, an epoxy-mercaptan reaction and Michael addition are promoted by a base such as an amine, hydrosilylation proceeds rapidly in the presence of a transition metal catalyst such as platinum, and the formation of a urethane or a urea proceeds rapidly by the use of a tin catalyst.

It is preferable to use as a polymer matrix in the present invention an isocyanate-hydroxyl addition polymer, an isocyanate-thiol addition polymer, an epoxy-thiol addition polymer, etc. since it is possible to ensure an appropriate pot life and to use them at a moderate curing temperature.

It is preferable in the present invention that the polymer matrix is formed by isocyanate-hydroxyl addition polymerization (urethane formation) and the polymerizable monomer is a (meth)acrylate.

It is also preferable in the present invention that the polymer matrix is an amorphous polyester and the polymerizable monomer is a (meth)acrylate.

Examples of polyisocyanates that can be used in the isocyanate-hydroxyl addition polymer in the present invention include tolylene diisocyanate, 4,4'-diphenylmethane diisocyanate, 4,4'-dicyclohexylmethane diisocyanate, hexamethylene diisocyanate, isophorone diisocyanate, and biurets, isocyanurates, adducts, and prepolymers of these isocyanates.

Examples of polyols that can be used in the isocyanate-hydroxyl addition polymer in the present invention include low molecular weight polyols, polyether polyols, polyester polyols, polycaprolactones, and polycarbonate diols.

Examples of the low molecular weight polyols include ethylene glycol, propylene glycol, cyclohexanedimethanol, 3-methyl-1,5-pentanediol, glycerol, trimethylolpropane, ethylene oxide-modified forms thereof, and propylene oxide-modified forms thereof.

Examples of the polyether polyols include polyethylene glycol, polypropylene glycol, and polytetramethylene glycol.

Examples of the polyester polyols include reaction products of ethylene glycol, propylene glycol, cyclohexanedimethanol, or 3-methyl-1,5-pentanediol with an acid component such as a dibasic acid such as adipic acid, succinic acid, phthalic acid, hexahydrophthalic acid, or terephthalic acid, or the acid anhydride thereof.

When the isocyanate-hydroxyl addition polymer is utilized in the present invention, an ethylenically unsaturated double bond that can polymerize with the photopolymerizable monomer may be incorporated into the matrix. That is, with regard to a starting compound that can be used for the incorporation, a compound having both a hydroxyl group and a reactive group, or a compound having both an isocyanate group and a reactive group may be used; the compound having a hydroxyl group and a reactive group, which is readily available industrially, is preferable, and examples thereof include a (meth)acrylate compound having a hydroxyl group.

Examples of the (meth)acrylate compound having a hydroxyl group include an adduct between an epoxy compound and (meth)acrylic acid, which is known as an epoxy (meth)acrylate. Examples of the adduct include the (meth)acrylic acid adduct of a polyglycidyl ether of a polyol such as (poly)ethylene glycol, (poly)propylene glycol, trimethylolpropane, or glycerol, the (meth)acrylate of a bisphenol A epoxy resin, and the (meth)acrylate of a phenol or cresol novolac epoxy resin.

When the isocyanate-thiol addition polymer or the epoxy-thiol addition polymer is utilized in the polymer matrix of the present invention, a method may be selected in which the matrix is cured in the presence of a polyene monomer using an excess amount of a thiol compound, and the polyene and the thiol group remaining in the matrix are then subjected to radical addition polymerization.

Examples of the thiol compound include simple thiols, thioglycolic acid derivatives, and mercaptopropionic acid derivatives.

Examples of the simple thiols include o-, *m*-, and *p*-xylenedithiols.

Examples of the thioglycolic acid derivatives include ethylene glycol bisthioglycolate, butanediol bisthioglycolate, and hexanediol bisthioglycolate.

Examples of the mercaptopropionic acid derivatives include ethylene glycol bisthiopropionate, butanediol bisthiopropionate, trimethylolpropane tristhiopropionate, pentaerythritol tetrakisthiopropionate, and trihydroxyethyltriisocyanuric acid tristhiopropionate.

Examples of epoxy compounds used in the epoxy-thiol addition polymer include polyglycidyl ethers of polyols such as (poly)ethylene glycol, (poly)propylene glycol, trimethylolpropane, and glycerol, alicyclic epoxies, bisphenol A epoxy resins, and phenol or cresol novolac epoxy resins.

### Chain transfer agent

As the chain transfer agent of the present invention, any type may be used as long as it enables the degree of polymerization of the produced polymer to be adjusted. Examples of the chain transfer agent include tertiary amines, alkyl thiols having on the order of 1 to 20 carbons, 2-substituted allyls, tertiary butyl sulfides, disulfide compounds, cumyl dithiobenzoates, alkyl halides such as carbon tetrachloride and carbon tetrabromide, triethylaluminum, metal ion-containing redox type catalysts, AIBNs, azo compounds, N-arylmaleimides, cobalt complexes of hematoporphyrin tetramethyl ether, addition-cleavage type chain transfer agents represented by formula (1) below, quinones, nitro/nitroso compounds, and styrene derivatives.

CH₂=C(-Y)-CH₂X (1)

In formula (1), Y denotes COOR₁ or a cyano group, R₁ denotes an alkyl group having 1 to 6 carbons, X denotes a bromine atom, SR₂, SnR₃, or SO₂Ar, R₂ denotes an alkyl group having 1 to 6 carbons, R₃ denotes an alkyl group having 1 to 6 carbons, and Ar denotes an aryl group.

Examples of the tertiary amine include trialkylamines such as triethylamine, tributylamine, *N,N*-diethylbutylamine, *N,N*-diethyl-*t*-octylamine, N,N-diisopropylethylamine, N,N-diisopropylisobutylamine, *N,N*-diisopropyl-1-ethylpropylamine, *N,N*-diisopropyl-2-ethylbutylamine, *N*-methyldicyclohexylamine, *N*-ethyldicyclohexylamine, and *N,N-*diethyl-*t*-octylamine; hydroxy group-containing trialkylamines such as N,N-dimethylethanolamine, *N*-methyldiethanolamine, and triethanolamine; and arylamines such as N,N-dimethylbenzylamine, N,N-diethylbenzylamine, methyl dimethylaminobenzoate, and tribenzylamine.

Examples of the styrene derivative include α-methylstyrene dimer (2,4-diphenyl-4-methyl-1-pentene).

Examples of the thiol include 1-butanethiol and *n*-dodecylmercaptan.

As the chain transfer agent in the present invention, the tertiary amines, thiols, styrene derivatives, etc. are preferable, the tertiary amines, styrene derivatives, etc. are more preferable, and the styrene derivatives, etc. are particularly preferable. The tertiary amines preferably have a low molecular weight of 50 to 250 and do not have a reactive group such as OH, NH₂, or SH.

### Plasticizer

In the present invention, the volume phase hologram recording material need not comprise a plasticizer, but it is preferable for it to be contained since distortion of the volume phase hologram recorded material can be suppressed. The plasticizer is preferably a plasticizer that is added to a synthetic resin, and examples thereof include dioctyl adipate and acetylcitric acid tributyrate.

The content of the plasticizer is preferably 30 parts by weight or less relative to 100 parts by weight of the polymer matrix, more preferably 15 parts by weight or less, and yet more preferably 5 parts by weight or less. When the content of the plasticizer exceeds 30 parts by weight, since the volume phase hologram recording material might be soft, the SN ratio of hologram recording might be poor. When the plasticizer is contained, the content is preferably 0.1 parts by weight or greater, and more preferably 0.5 parts by weight or greater.

### Composition of volume phase hologram recording material: polymer matrix and polymerizable monomer

In the volume phase hologram recording material of the present invention, the polymerizable monomer is preferably 1 to 50 parts by weight, more preferably 5 to 40 parts by weight, and yet more preferably 10 to 30 parts by weight relative to 100 parts by weight of the total of the polymer matrix and the polymerizable monomer. When the polymerizable monomer is less than 1 part by weight, since the amount of polymerization by irradiation with light for hologram recording is small, the SNR of hologram recording might be poor. Furthermore, when the polymerizable monomer exceeds 50 parts by weight, since the amount of polymerization by irradiation with light for hologram recording is large, the SNR of hologram recording might be poor.

### Composition of volume phase hologram recording material: polymerizable monomer and photopolymerization initiator

With regard to the composition of the polymerizable monomer and the photopolymerization initiator in the volume phase hologram recording material of the present invention, the photopolymerization initiator is preferably 0.1 to 20 parts by weight, more preferably 0.3 to 10 parts by weight, and yet more preferably 0.5 to 5 parts by weight relative to 100 parts by weight of the polymerizable monomer.

### Composition of volume phase hologram recording material: content of chain transfer agent

The content of the chain transfer agent in the volume phase hologram recording material of the present invention depends on the type of chain transfer agent, and the optimal amount varies accordingly. That is, the content of the chain transfer agent in the volume phase hologram recording material of the present invention may be adjusted according to a chain transfer constant of the chain transfer agent used. The content of the chain transfer agent is, for example, preferably 0.05 to 40 parts by weight relative to 100 parts by weight of the polymerizable monomer, more preferably 0.1 to 30 parts by weight, and yet more preferably 0.2 to 20 parts by weight. When the content is less than 0.05 parts by weight, control of polymerization is insufficient, the molecular weight increases, and the SNR of hologram recording might be poor. Furthermore, when the content exceeds 40 parts by weight, the progress of polymerization is insufficient, the molecular weight decreases, and the SNR of hologram recording might be poor.

Polymerization of the polymerizable monomer in the volume phase hologram recording material of the present invention is initiated by irradiation with light, and it turns into a polymer. The weight-average molecular weight of this produced polymer is preferable 3 × 10⁶ or less, more preferably 2.8 × 10⁶ or less, yet more preferably 1 × 10⁶ or less, and particularly preferably 5 × 10⁵ or less. The weight-average molecular weight of the produced polymer is preferably at least 1,000, more preferably at least 1,500, yet more preferably at least 2,000, and particularly preferably at least 5,000. It is also not desirable for the weight-average molecular weight of the produced polymer to exceed 3 × 10⁶ since the SNR of hologram recording might be poor. It is not desirable for the weight-average molecular weight of the produced polymer to be less than 1,000 since the SNR of hologram recording might be poor.

From a different perspective, the content of the chain transfer agent in the volume phase hologram recording material may be adjusted so that the molecular weight of the produced polymer is limited as described above. Depending on the molecular weight of the polymerizable monomer used, the above-mentioned lower limit for the molecular weight of the produced polymer might not be satisfied. In this case, control may be carried out by the degree of polymerization rather than the molecular weight of the produced polymer. That is, the produced polymer is preferably a trimer or higher polymer, more preferably a tetramer or higher polymer, and yet more preferably a pentamer or higher polymer.

In a recorded material in which a hologram has been recorded using the volume phase hologram recording material of the present invention with information light and reference light, the produced polymer is present in the form of particles. That is, compared with an existing hologram recorded material in which the produced polymer is present in the form of bands, the amount of irradiation required for recording and the amount of polymerizable monomer can be reduced. It is also possible to reduce the recorded area compared with an existing one. From the above, the volume phase hologram recording material of the present invention can record information at high density.

### Preparation of volume phase hologram recorded material

The volume phase hologram recording material of the present invention may be produced by any method as long as a hologram can be recorded and read out. For example, a plate that is transparent to hologram recording light/reading-out light and a guide light may be coated with the volume phase hologram recording material of the present invention or it may be poured between two transparent plates of this type, or a sheet-shaped volume phase hologram recording material may be interposed between two transparent plates of this type.

Examples of the plate that is transparent to hologram recording light/reading-out light and a guide light used in the volume phase hologram recorded material of the present invention include glass, polycarbonate, polyethylene, polypropylene, polyvinyl chloride, polyvinylidene chloride, polystyrene, polyacrylate, and polymethacrylate. Two kinds of such plates may be used. That is, it may be prepared by applying or pouring the volume phase hologram recording material of the present invention onto a glass plate, or placing a sheet thereon, and then using a sheet of polycarbonate, polypropylene, etc. In this process, the recorded material may be adjusted so as to have a desired thickness by inserting a spacer between the plates. This spacer may also be used as a seal for the recorded material.

The thickness of the recording layer in the volume phase hologram recorded material is preferably 5 to 5,000 µm, more preferably 20 to 3,000 µm, and yet more preferably 100 to 1,000 µm. The recording layer comprises the volume phase hologram recording material of the present invention. It is undesirable for the thickness of the recording layer to be less than 5 µm since the SNR of the hologram recording might be poor, or for it to exceed 5,000 µm since distortion is caused in the recording layer and the SNR of the hologram recording might be poor.

### Hologram recording light

Recording of a hologram may be carried out by irradiation with light at 350 to 700 nm. Examples of the irradiation light include a GaN-based semiconductor blue laser, an argon ion laser, a krypton ion laser, and a YAG laser.

### Hologram recording method

The volume phase hologram recording material of the present invention may be applied to any hologram recording method, such as a polarized collinear hologram recording method in which reference light and information light are aligned on the same optical axis or a 2 beam type hologram recording method in which the incident angle of the reference light is variable. The volume phase hologram recording material of the present invention is preferably used in the collinear hologram recording method and the variable incident angle reference light type hologram recording method, and is more preferably used in the polarized collinear hologram recording method.

### Uses of volume phase hologram recording material

Other than a volume hologram recording medium, the volume phase hologram recording material of the present invention may be used in optical devices, incorporation into displays/designs, interference measurement, optical information processing, and optical information recording.

Specific examples of the optical devices include diffraction gratings, POS scanners, CD/DVD player optical heads, beam splitters, interference filters, and airplane/automobile head-up displays.

Specific examples of the incorporation into displays/designs include hologram art, indoor/outdoor decoration, recording of arts and crafts, educational materials, book/magazine covers and illustrations, embellishment and forgery prevention of securities, ID cards, credit cards, cash cards, telephone cards, etc., and 3D viewing of a CT image.

Specific examples of the interference measurement include measurement of displacement and deformation of an object, measurement of vibration of an object, and measurement of precision of an optical face (computer-generated hologram).

Specific examples of the optical information processing include fingerprint verification and pattern recognition employing a holographic matched filter.

Specific examples of the optical information recording include image recording for (high-definition or digital) television broadcasting, video camera pictures, and surveillance camera pictures, information retrieval and recording, graphic character input devices, and holographic associative memory.

### EMBODIMENTS

A volume phase hologram recording material, in hologram recording of data using information light and reference light, the material comprising a chain transfer agent.

A hologram recording system employing a volume phase hologram recording material that gives a produced polymer that has been polymerized by interference fringes generated from information light and reference light and that has a molecular weight of 1,000 to 3,000,000.

A volume phase hologram recorded material comprising a produced polymer that has been polymerized by interference fringes generated from information light and reference light and that is at least a trimer with a weight-average molecular weight no greater than 3,000,000.

A volume phase hologram recording material in which the difference in refractive index between a polymer matrix and a polymerizable monomer is at least 0.0001.

A volume phase hologram recording material comprising a chain transfer agent, the difference in refractive index between a polymer matrix and a polymerizable monomer being at least 0.0001.

### Examples

The present invention is explained more specifically by reference to Examples and Comparative Examples, but the present invention is not limited thereto. 'Parts' below means parts by weight.

### Example 1

### Preparation of recording medium

100 parts of a glycerol propylene oxide modified material (G-400, G-400 manufactured by Asahi Denka Co., Ltd, molecular weight about 400), 55 parts of hexamethylene diisocyanate (HDI, Duranate HDI manufactured by ASAHI KASEI CORPORATION), 0.02 parts of dibutyltin dilaurate (DBTL, manufactured by Asahi Denka Co., Ltd), 17 parts of 2,4-dibromophenyl acrylate (DBPA), 2.6 parts of Irgacure 784 (Irg 784, manufactured by Ciba Specialty Chemicals), and 3.9 parts of N,N-dimethylbenzylamine (DMBnA) were mixed well at 25°C for 30 minutes to give a uniform recording medium composition A.

500 µm thick polytetrafluoroethylene poly(ethylene tetrafluoride) tape was affixed to three edges of a glass substrate (50 × 50 × 1 mm) as a spacer, and a vapor-deposited aluminum layer (reflection layer)-equipped glass substrate (50 × 50 × 1 mm) was further mounted thereon to thus give a sample cell. The composition prepared above was injected into this sample cell through one edge and heated at 80°C for 2 hours to thus cure a matrix, thereby giving recording medium A.

### Data recording

Data recording was carried out using the recording medium A prepared above, by means of a SHOT-1000 collinear hologram information recorder manufactured by Pulstec Industrial Co., Ltd. under the conditions below. The recording medium 6 was set in a holder so that laser irradiation during recording and reproduction was carried out from the direction of the top in FIG. 1, and the position was adjusted so that the laser came to focus on the vapor-deposited aluminum layer (reflection layer). Reading was carried out 30 sec. after writing, and the error rate (BER, bit error rate) during data recording was measured. The results are given in Table 1. The information pattern employed standard equipment (test information pattern of about 1600 bytes).

### (Data recording conditions)

Recording/reproduction laser wavelength: 532 nm (Nd: YVO4)
Recording laser intensity: 0.6 mW (pulse width 10 nsec, repetition interval 50 µsec)
Information light/reference light intensity ratio = 1.0
Number of recording pulses: 200, 1000, 2000 pulses
(Data reading conditions)
Read laser intensity: 0.75 mW to 0.1 mW (pulse width 10 nsec, repetition interval 50 µsec, adjusted by intensity of CMOS image)
Number of read pulses: 20 pulses.

### Example 2

The procedure of Example 1 was repeated except that, instead of DMBnA, 0.4 parts of 2,4-diphenyl-4-methyl-1-pentene (MSD, Nofmer MSD manufactured by NOF Corporation) was used and Irg 784 was changed to 2.5 parts, thus giving recording medium B. The BER thereof was measured. The results are given in Table 1.

### Comparative Example 1

The procedure of Example 1 was repeated except that DMBnA was excluded from the composition, thus giving comparative recording medium A. The error rate during data recording was measured using comparative recording medium A under the same data recording conditions and data read-out conditions as described in Example 1. The results are given in Table 1.

**(Table 1)**

| | 200 pulses | 1000 pulses | 2000 pulses |
|---|---|---|---|
| Recording medium A | < 10⁻⁴ | < 10⁻⁴ | < 10⁻⁴ |
| Recording medium B | < 10⁻⁴ | < 10⁻⁴ | < 10⁻⁴ |
| Comparative recording medium A | > 1 | 6 × 10⁻³ | 1 × 10⁻³ |

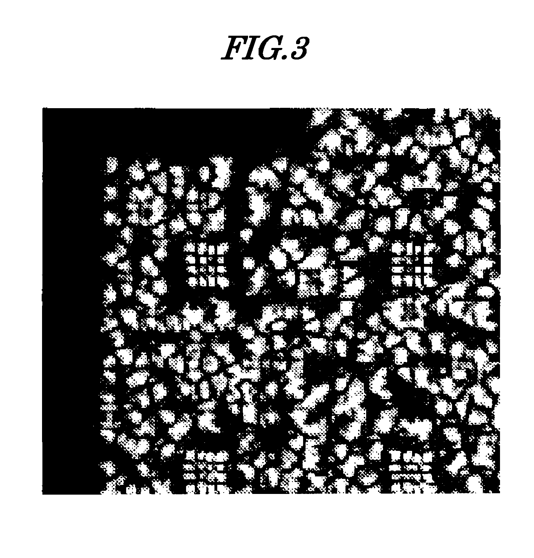

Comparative recording medium A showed degradation in the BER for all the numbers of recording pulses used for the test, but the recording medium of the present invention did not show such degradation in the BER. When a comparison was made between a reproduced image from recording medium A (FIG. 2) and a reproduced image from comparative recording medium A (FIG. 3), neither distortion nor spreading was observed in the reproduced image from recording medium A.

### Example 3

100 parts of an amorphous polyester (Vylon 550, Toyobo Co., Ltd. Vylon 650), 11 parts of DBPA, 1.6 parts of Irg 784, and 2 parts of *n*-dodecylmercaptan (DM, manufactured by Aldrich) as a chain transfer agent were added to 230 parts of toluene and mixed well at a room temperature of 25°C for 30 minutes to give a uniform solution. This mixed solution was placed in a vacuum dryer, and toluene was removed under reduced pressure at 25°C and 13.3 kPa and was then further removed under vacuum while heating at 60°C and 40 kPa until there was 0.1 parts or less of toluene, thus giving a viscous recording medium composition C.

A substrate was prepared by affixing 500 µm thick polytetrafluoroethylene poly(ethylene tetrafluoride) tape to 4 edges of a glass substrate (50 × 50 × 1 mm) as a spacer. This substrate was placed horizontally, and 2 g of composition C was placed in a middle part thereof. This was covered by a vapor-deposited aluminum layer (reflection layer)-equipped glass substrate (50 × 50 × 1 mm), it was placed in a press heated at 80°C, and composition C was spread over the substrate by gradually applying pressure for 20 minutes. When a predetermined thickness was achieved, pressing was carried out at a pressure of 10 kg/cm² for 1 hour, thus giving recording medium C. The BER during data recording was measured under the same data recording conditions and data read-out conditions as described in Example 1. The results are given in Table 2.

### Example 4

The procedure of Example 3 was repeated except that instead of DM, 0.5 parts of MSD was used, thus giving recording medium D. The BER during data recording was measured under the same data recording conditions and data read-out conditions as described in Example 1. The results are given in Table 2.

### Comparative Example 2

The procedure of Example 3 was repeated except that DM was excluded from composition C, thus giving comparative recording medium C. The BER during data recording was measured using comparative recording medium C under the same data recording conditions and data read-out conditions as described in Example 1. The results are given in Table 2.

**(Table 2)**

| | 200 pulses | 1000 pulses | 2000 pulses |
|---|---|---|---|
| Recording medium C | < 10⁻⁴ | < 10⁻⁴ | < 10⁻⁴ |
| Recording medium D | < 10⁻⁴ | < 10⁻⁴ | < 10⁻⁴ |
| Comparative recording medium C | > 1 | 2 × 10⁻² | 6 × 10⁻² |

### Example 5

A uniform master batch was prepared by stirring 97.5 parts of DBPA and 2.5 parts of Irg 784 at 30°C to 40°C for about 2 hours.

0.01 mol of *N*-ethyldicyclohexylamine (EDCHA) was added as a chain transfer agent to 100 g of the master batch, and the mixture was stirred at 35°C for about 1 hour, thus giving a uniform recording medium composition 1.

### Light irradiation and measurement of molecular weight of produced polymer

5 mg of composition 1 prepared above was sampled in an aluminum (Al) pan, having a diameter of 5 mm and a depth of 3 mm, of a UV lamp-equipped differential scanning calorimeter (hereinafter, Photo-DSC system, DSC229C-UV1 manufactured by Seiko Instruments Inc.), set in the Photo-DSC system, and irradiated with light (irradiation intensity 16 J/cm²) under a nitrogen atmosphere at 30°C. In this irradiation with light, a UV lamp device of the Photo-DSC system was equipped with a bandpass filter having a center wavelength of 500 nm and a half value width of 50 nm and an optical filter for cutting wavelengths of 480 nm or below so as to give monochromatic light at 500 nm and adjust the irradiation light intensity to 4.5 mW/cm² at the position where the Al pan was set.

The sample was taken out from the Al pan after the irradiation with light, dissolved in 2 mL of a tetrahydrofuran (THF) solution, filtered by means of a membrane filter having a pore size of 0.45 µm, and subjected to gel permeation chromatography (GPC: HLC-8120GPC manufactured by Tosoh Corporation) to thus measure the weight-average molecular weight (Mw, polystyrene basis). The results are given in Table 3. GPC measurement conditions were as follows.
Column: TSKgel GMHXL-L × 3, manufactured by Tosoh Corporation
Mobile phase: THF
Flow rate: 1.0mL/min
Column temperature: 40°C
Amount of sample injected: 100 µL

### Example 6

The procedure of Example 5 was repeated except that *N,N*-diisopropyl-1-ethylpropylamine (DiPEPA) was used as a chain transfer agent, thus preparing recording medium composition 2. In the same manner as in Example 5, this was irradiated with light, and the molecular weight of the produced polymer was measured. The results are given in Table 3.

### Example 7

The procedure of Example 5 was repeated except that DMBnA was used as a chain transfer agent, thus preparing recording medium composition 3. In the same manner as in Example 5, this was irradiated with light, and the molecular weight of the produced polymer was measured. The results are given in Table 3.

### Example 8

The procedure of Example 5 was repeated except that MSD was used as a chain transfer agent, thus preparing recording medium composition 4. In the same manner as in Example 5, this was irradiated with light, and the molecular weight of the produced polymer was measured. The results are given in Table 3.

### Example 9

The procedure of Example 5 was repeated except that DM was used as a chain transfer agent, thus preparing recording medium composition 5. In the same manner as in Example 5, this was irradiated with light, and the molecular weight of the produced polymer was measured. The results are given in Table 3.

### Example 10

The procedure of Example 5 was repeated except that N,N-diethylbenzylamine (DEBnA) was used as a chain transfer agent, thus preparing recording medium composition 6. In the same manner as in Example 5, this was irradiated with light, and the molecular weight of the produced polymer was measured. The results are given in Table 3.

### Comparative Example 3

The master batch prepared in Example 5 was used as it was. That is, this master batch was defined as comparative recording medium composition 1.

This comparative recording medium composition 1 was irradiated with light in the same manner as in Example 5, and the molecular weight of the produced polymer was measured. The results are given in Table 3.

**(Table 3)**

| | Chain transfer agent added | Mw |
|---|---|---|
| Recording medium composition 1 | EDCHA | 7.5 × 10³ |
| Recording medium composition 2 | DiPEPA | 5.6 × 10³ |
| Recording medium composition 3 | DMBnA | 4.7 × 10⁵ |
| Recording medium composition 4 | MSD | 2.0 × 10³ |
| Recording medium composition 5 | DM | 1.4 × 10⁴ |
| Recording medium composition 6 | DEBnA | 7.0 × 10⁴ |
| Comparative recording medium composition 1 | None | 3.3 × 10⁶ |

### Result of molecular weight measurement

Compared with comparative recording medium composition 1, to which no chain transfer agent had been added, the weight-average molecular weight of the recording medium compositions, to which a chain transfer agent had been added, had decreased by 10 times or greater, thus showing that it was possible to control the molecular weight.

The 3D shape of a polymer, that is, the particle size, can be expressed as a rotating radius determined from light scattering; the rotating radius Rg and the molecular weight Mw have the relationship Rg² = aMw^{x} (a is a proportionality constant ≈ 7.6 × 10⁻²² m, and x is a coefficient that depends on the molecular shape; in the case of a Gaussian molecular chain having a free 3D structure, x = 0.5 to 0.6; ref. Comprehensive Polymer Science, Vol. 1 Polymer Characterization, C. Booth, C. Price (Ed.), Pergamon Press, 1989, pp 103-132. and J. P. Cotton, et al., Macromolecules, Vol. 7, 863-872, 1974. In the present invention, calculation was carried out with x = 0.6). The results of calculating, from the molecular weight obtained, the rotating radius, which corresponds to the particle size, suggested that the particle size of the composition to which a chain transfer agent had been added decreased by more than half compared with the comparative recording medium composition 1, to which none had been added.

### Example 11

A uniform master batch was prepared by mixing well 100 parts of G-400, 55 parts of HDI, 0.02 parts of DBTL, 17 parts of DBPA, and 2.6 parts of Irg 784 at 25°C for 30 minutes.

DMBnA was added as a chain transfer agent to 100 parts of this master batch in the addition amounts (wt %) as shown in Table 4, and the mixture was stirred at 25°C for about 10 minutes, thus preparing uniform recording medium compositions 7 to 9. These recording medium compositions 7 to 9 were placed in sample cells (the same as described in Example 1), thus giving recording media 7 to 9. These recording media were subjected to recording of page data images (5000 pulses, irradiated light intensity 500 mJ/cm²) using a SHOT-1000 collinear holographic tester (manufactured by Pulstec Industrial Co., Ltd.). These were reproduced and the BER was measured. The results are given in Table 4.

In order to examine the molecular weight of the polymerization products in this process, the following experiment was carried out.

The light emission site of a halogen lamp device was equipped with a bandpass filter having a center wavelength of 500 nm and a half value width of 50 nm and an optical filter for cutting wavelengths of 480 nm or below so as to give monochromatic light at 500 nm and adjust the irradiated site area to about 5 cm² and the irradiation light intensity at the site to 10 mW/cm². A recording medium prepared by the same steps as above was placed at this site, and irradiated with light corresponding to 500 mJ/cm². Subsequently, the upper and lower glass substrates were peeled off, and a 1 cm × 1 cm piece of the irradiated site of the recording material was cut out and ground. This was placed in a vial, 20 mL of a THF solution was further added thereto, and the mixture was allowed to stand for 24 hours, thus immersion-leaching the polymer. After filtering the solution mixture by means of a membrane filter having a pore size of 0.45 µm, the weight-average molecular weight (Mw, polystyrene basis) of the leached component was measured by gel permeation chromatography in the same manner as in Example 5. This results are also given in Table 4.

### Example 12

The procedure of Example 11 was repeated except that instead of DMBnA DEBnA was used, thus preparing recording media 10 and 11, and the BER thereof and the molecular weight of the produced polymers were measured. The results are given in Table 4.

### Example 13

The procedure of Example 11 was repeated except that instead of DMBnA DiPEA was used, thus preparing recording media 12 to 16, and the BER thereof and the molecular weight of the produced polymers were measured. The results are given in Table 4.

### Example 14

The procedure of Example 11 was repeated except that instead of DMBnA N-ethyldicyclohexylamine (EDCHA) was used, thus preparing recording media 17 to 20, and the BER thereof and the molecular weight of the produced polymers were measured. The results are given in Table 4.

### Example 15

The procedure of Example 11 was repeated except that instead of DMBnA MSD was used, thus preparing recording media 21 to 23, and the BER thereof and the molecular weight of the produced polymers were measured. The results are given in Table 4.

### Comparative Example 4

The procedure of Example 11 was repeated except that a chain transfer agent was not added, thus preparing comparative recording medium 2, and the BER thereof and the molecular weight of the produced polymer were measured. The results are given in Table 4.

**(Table 4)**

| | Chain transfer agent | Amount added | BER | Mw |
|---|---|---|---|---|
| Recording medium 7 | DMBnA | 0.2 | 8.5 × 10⁻² | 3.0 × 10⁶ |
| Recording medium 8 | DMBnA | 0.5 | 2.5 × 10⁻² | 9.0 × 10⁵ |
| Recording medium 9 | DMBnA | 2 | 1.3 × 10⁻⁴ | 1.6 × 10⁵ |
| Recording medium 10 | DEBnA | 0.5 | 7.2 × 10⁻³ | 1.1 × 10⁵ |
| Recording medium 11 | DEBnA | 2 | 3.1 × 10⁻⁴ | 3.6 × 10⁴ |
| Recording medium 12 | DiPEA | 0.01 | 5.8 × 10⁻² | 2.8 × 10⁶ |
| Recording medium 13 | DiPEA | 0.05 | 3.5 × 10⁻³ | 4.4 × 10⁵ |
| Recording medium 14 | DiPEA | 0.1 | 1.1 × 10⁻² | 1.3 × 10⁵ |
| Recording medium 15 | DiPEA | 0.5 | 1.0 × 10⁻⁵ | 1.5 × 10⁴ |
| Recording medium 16 | DiPEA | 1 | 1.0 × 10⁻⁵ | 7.0 × 10³ |
| Recording medium 17 | EDCHA | 0.5 | 3.8 × 10⁻⁴ | 2.4 × 10⁴ |
| Recording medium 18 | EDCHA | 0.8 | 1.5 × 10⁻⁴ | 1.7 × 10⁴ |
| Recording medium 19 | EDCHA | 1 | 1.0 × 10⁻⁵ | 1.3 × 10⁴ |
| Recording medium 20 | EDCHA | 2 | 1.0 × 10⁻⁵ | 7.7 × 10³ |
| Recording medium 21 | MSD | 0.2 | 1.0 × 10⁻⁵ | 5.5 × 10⁴ |
| Recording medium 22 | MSD | 0.4 | 1.0 × 10⁻⁵ | 2.3 × 10⁴ |
| Recording medium 23 | MSD | 0.8 | 1.0 × 10⁻⁵ | 8.5 × 10³ |
| Comparative recording medium 2 | - | - | 1.6 × 10⁻¹ | 3.3 × 10⁶ |

## Claims

1. A volume phase hologram recording material comprising a polymerizable monomer that is photopolymerizable by means of interference fringes generated from information light and reference light,
the recording material comprising a polymer matrix, a photopolymerization initiator, and a chain transfer agent, and
the chain transfer agent having a content that enables the weight-average molecular weight of a polymer produced by photopolymerization to be controlled within the range of 1,000 to 3,000,000.

2. The volume phase hologram recording material according to Claim 1, wherein the polymerizable monomer is a radically polymerizable monomer, and the chain transfer agent is a chain transfer agent for radical polymerization.

3. A volume phase hologram recording material comprising a polymerizable monomer that is photopolymerizable by means of interference fringes generated from information light and reference light,
the polymerizable monomer comprising a (meth)acrylic acid ester,
the recording material comprising an amorphous polyester as a polymer matrix, and
the recording material comprising a chain transfer agent selected from the group consisting of a tertiary amine, an alkylthiol, a tertiary butyl sulfide, a disulfide compound, an alkyl halide, and α-methylstyrene dimer.

4. The volume phase hologram recording material according to Claim 3, wherein the polymer matrix is an amorphous polyester, the polymerizable monomer comprises a (meth)acrylic acid ester as a main component, and the chain transfer agent is selected from the group consisting of a tertiary amine, an alkylthiol, a tertiary butyl sulfide, a disulfide compound, an alkyl halide, and α-methylstyrene dimer.

5. The volume phase hologram recording material according to Claim 3 or 4, wherein the chain transfer agent is a trialkylamine selected from the group consisting of triethylamine, tributylamine, N,N-diethylbutylamine, N, N-diethyl-t-octylamine, *N,N*-diisopropylethylamine, N,N-diisopropylisobutylamine, *N,N-*diisopropyl-1-ethylpropylamine, *N,N*-diisopropyl-2-ethylbutylamine, *N*-methyldicyclohexylamine, N-ethyldicyclohexylamine, and *N,N*-diethyl-*t*-octylamine.

6. The volume phase hologram recording material according to any one of Claims 3 to 5, wherein the polymerizable monomer is selected from the group consisting of phenyl (meth)acrylate, tribromophenyl (meth)acrylate, dibromophenyl (meth)acrylate, monobromophenyl (meth)acrylate, phenylphenyl (meth)acrylate, cumylphenyl (meth)acrylate, and alkylene oxide-modified forms thereof.

7. The volume phase hologram recording material according to any one of Claims 1 to 6, wherein the chain transfer agent is contained at 0.05 to 40 parts by weight relative to 100 parts by weight of the polymerizable monomer.

8. A volume phase hologram recording material comprising a polymerizable monomer that is photopolymerizable by means of interference fringes generated from information light and reference light,
the polymerizable monomer comprising a (meth)acrylic acid ester as a main component,
the recording material comprising an isocyanate-hydroxy addition polymer as a polymer matrix, and
the recording material comprising a chain transfer agent selected from the group consisting of a tertiary amine, a tertiary butyl sulfide, a disulfide compound, an alkyl halide, and α-methylstyrene dimer.

9. A volume phase hologram recorded material comprising a polymer produced by polymerization of a polymerizable monomer by means of interference fringes generated from information light and reference light, the polymer having a weight-average molecular weight of 1,000 to 3,000,000.

10. A process for producing a volume phase hologram recording material, the process comprising:
a step of preparing a composition comprising a polymer matrix, a polymerizable monomer, a photopolymerization initiator, and a chain transfer agent, and
a step of forming a polymer from the polymerizable monomer in the presence of the chain transfer agent by generating in the composition interference fringes from information light and reference light.

11. The process for producing a volume phase hologram recording material according to Claim 10, wherein the polymer matrix is an amorphous polyester, the polymerizable monomer is a (meth)acrylic acid ester, and the chain transfer agent is selected from the group consisting of a tertiary amine, an alkylthiol, a tertiary butyl sulfide, a disulfide compound, an alkyl halide, and α-methylstyrene dimer.

12. The process for producing a volume phase hologram recording material according to Claim 10 or 11, wherein the polymer matrix is a urethane-based polymer, the polymerizable monomer is a (meth)acrylic acid ester, and the chain transfer agent is selected from the group consisting of a tertiary amine, a tertiary butyl sulfide, a disulfide compound, an alkyl halide, and α-methylstyrene dimer.

13. The process for producing a volume phase hologram recording material according to any one of Claims 10 to 12, wherein the chain transfer agent is a trialkylamine selected from the group consisting of triethylamine, tributylamine, N,N-diethylbutylamine, N,N-diethyl-t-octylamine, N,N-diisopropylethylamine, *N,N-*diisopropylisobutylamine, *N,N-*diisopropyl-1-ethylpropylamine, *N,N*-diisopropyl-2-ethylbutylamine, N-methyldicyclohexylamine, N-ethyldicyclohexylamine, and *N,N*-diethyl-*t*-octylamine.

14. The process for producing a volume phase hologram recording material according to any one of Claims 10 to 13, wherein the polymerizable monomer is selected from the group consisting of phenyl (meth)acrylate, tribromophenyl (meth)acrylate, dibromophenyl (meth)acrylate, monobromophenyl (meth)acrylate, phenylphenyl (meth)acrylate, cumylphenyl (meth)acrylate, and alkylene oxide-modified forms thereof.

15. The process for producing a volume phase hologram recording material according to any one of Claims 10 to 13, wherein the polymerizable monomer is a halogen atom-containing (meth)acrylate selected from the group consisting of trifluoroethyl, tetrafluoropropyl, heptadecafluorodecyl, octafluoropentyl, and 2,3-dibromopropyl.

16. The process for producing a volume phase hologram recording material according to any one of Claims 10 to 15, wherein the chain transfer agent is contained at 0.05 to 40 parts by weight relative to 100 parts by weight of the polymerizable monomer.
